# EUROPEAN PATENT SPECIFICATION

(11) **EP 2 053 414 B1**
(45) Date of publication and mention of the grant of the patent: **03.07.2013**
(21) Application number: 08014303.5
(22) Date of filing: 11.08.2008
(51) Int. Cl.: G01R 31/36

(54) **Method and apparatus for detecting internal information of secondary battery**
Verfahren und Vorrichtung zur Erkennung interner Informationen einer Sekundärbatterie
Procédé et appareil pour détecter les informations internes d'une batterie secondaire

(30) Priority: 07.09.2007 JP 2007232546; 22.01.2008 JP 2008011599
(43) Date of publication of application: 29.04.2009
(73) Proprietor: HITACHI VEHICLE ENERGY, LTD., Hitachinaka-shi Ibaraki 312-0061 (JP)
(72) Inventor: Honkura, Kohei, Tokyo 100-8220 (JP)
(74) Representative: Kirschner, Klaus Dieter

(56) References cited:
- EP-A2- 0 987 555
- JP-A- 2003 157 910

## Description

### BACKGROUND OF THE INVENTION

### 1. Field of the Invention

The present invention relates to a method for detecting internal information of a secondary battery and an apparatus equipped with a function thereof.

### 2. Description of the Related Art

It has been known that a secondary battery (lithium secondary battery, for example) is deteriorated and reduced in capacity when it performs storage or conducts charge-discharge cycles under a high temperature environment or in a state of a deep charge depth. Once the capacity of the battery is reduced, the battery is not restored to its original battery capacity even though sufficient charging is done. This capacity reduction is considered to occur due to a decrease in each electrode material that contributes to charging and discharging of positive and negative electrodes, an irreversible chemical reaction at an interface between the electrode material and an electrolytic solution, etc. Once a battery was fabricated, it was difficult to determine these deterioration factors in the battery separately without disassembling the battery. Therefore, a conventional battery state determining method was one aimed at determining the degree of deterioration of an overall battery.

The secondary battery is used at a battery voltage lying in a predetermined range or in a charged state. With the deterioration of the secondary battery, however, a positive electrode potential and a negative electrode potential varies corresponding to a given battery voltage or a charged state change. Therefore, when the secondary battery continues to use in the same battery voltage range or charge state range as before the deterioration, the positive electrode potential or the negative electrode potential falls into an undesired region, thus causing a possibility that the lifetime of the battery and its safety will be degraded. Since the positive electrode potential and the negative electrode potential could not be acquired separately with a high degree of accuracy in a conventional internal information detecting method, it was difficult to avoid such a situation.

As a typical secondary battery deterioration determining method proposed up to now, such a method for making a decision as to deterioration of a battery using a change ΔV in battery voltage per predetermined time, etc. are disclosed , for example , in Japanese Unexamined Patent Publication No. 2002-340997 andJapanese Unexamined Patent Publication No. 2001-292534.

The above secondary battery deterioration determining method is brining the rate of deterioration of the overall battery into digitization. The method is however accompanied by the problem that even though the rate of deterioration of the overall battery is determined, it is not possible to determine the situations of the positive and negative electrodes and the irreversible chemical reaction in the battery respectively, thereby causing a limit to the range of applications thereof.

The JP 2003 157910 A is concerned with the problem to obtain a lead-acid battery negative electrode deterioration judging method which can determine a degree of deterioration of a negative electrode under the condition where the lead-acid battery is not mounted to the device using the lead-acid battery. For this purpose, a plurality of discharging/charging cycle are applied to the lead-acid battery in use or the same after use, and a potential curve at that time is measured by using a reference electrode, and the negative electrode potential curve is compared with that of unused battery, and the state of deterioration is determined from the potential variation at the last stage of discharge and the same at the initial stage of charging.

EP 0 987 555 A1 discloses a method of measuring quantities that indicates the state of an electrochemical device having an electrode and an ionic conductor, such as material properties or a residual capacity, without disassembling the device. The quantities are measured by comparing a series of theoretical data of an electrical characteristic of the device obtained by combining at least one of an electron transportation model of the electrode, an ion transportation model of the electrode, an ion conduction model of the ionic conductor and a model of an electrochemical reaction taking place in an interface between the electrode and the ionic conductor, with a potential model of said electrode, with a series of measured data of the electrical characteristic of the electrochemical device.

In the state of the art, a problem arises in that there is a need to disassemble the battery to determine the situations of the positive and negative electrodes and the irreversible chemical reaction in the battery respectively, thus disenabling the use of the battery.

The present invention has been made to solve the above problems.

It is an object of the present invention to provide a technique for detecting the situation of a positive electrode in a secondary battery and the situation of a negative electrode therein without disassembling the battery and a simple method.

In view of this object, the invention provides the method of claim 1 and the apparatus of claim 10. Preferred embodiments of the invention are characterized in the subclaims.

The present inventors have found out that when a secondary battery is charged and discharged at small currents, the resulting charge (or discharge) curves of the secondary battery are satisfactorily reproduced by performing a calculation for superimposing charge (or discharge) curves of single positive and negative electrodes, which are measured separately.

It is enough if a positive-electrode active material mass mₚ that contributes to the charge (or discharge), a negative-electrode active material mass mₙ that contributes to the charge (or discharge), and an index C about a position relationship between the charge (or discharge) curves of the positive and negative electrodes are defined or fixed as parameters used in the above calculation. Incidentally, the "active material mass that contributes to the charge (or discharge)" is represented as "effective active material mass" in the present specification.

### BRIEF DESCRIPTION OF THE DRAWINGS

Fig. 1 is a schematic configuration diagram of an internal information detecting apparatus;
Fig. 2 is a flowchart for describing a reproduction calculating process;
Fig. 3 is a diagram showing the configuration of a parameter table;
Fig. 4 is a typical diagram illustrating discharge curves of a positive electrode, a negative electrode and an overall battery; and
Fig. 5 is a typical diagram showing differential discharge curves of a positive electrode, a negative electrode and an overall battery.

### DETAILED DESCRIPTION OF THE PREFERRED EMBODIMENTS

Preferred embodiments of the present invention will next be explained using the drawings. It should be noted that the present invention is not limited to the embodiments to be described below. It should also be noted that a subscript p indicates a positive electrode and a subscript n indicates a negative electrode subsequently.

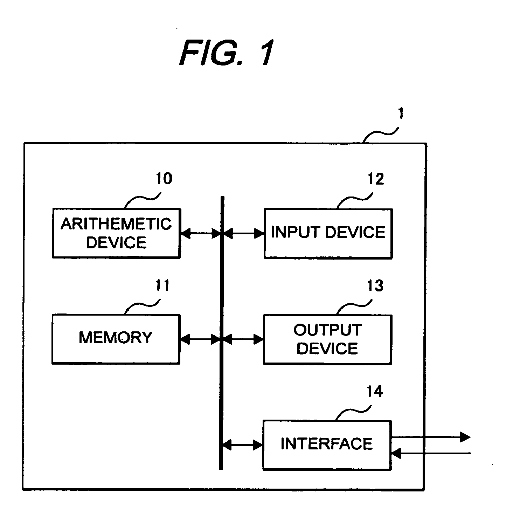

Fig. 1 is a schematic configuration diagram of an apparatus called internal information detecting apparatus 1 for detecting internal information of a lithium secondary battery. The internal information detecting apparatus 1 is achieved by a computer system equipped with a computing or arithmetic device 10 such as a CPU, a memory 11 such as a RAM, a ROM or the like, an input device 12 such as a keyboard, a mouse, an output device 13 such as a display, and an interface 14 to an external device. The internal information detecting apparatus 1 is connected to a device (not shown) which acquires internal information such as a voltage change and the like from a battery to be detected called "detected battery"hereinafter.

Incidentally, while a description is made below of the case in which internal information is detected paying attention to the discharge characteristics of the battery, internal information related to its charge characteristics can also be detected as a matter of course. When the internal information related to the charge characteristics is detected, "discharge" may be read as "charge" in the following description.

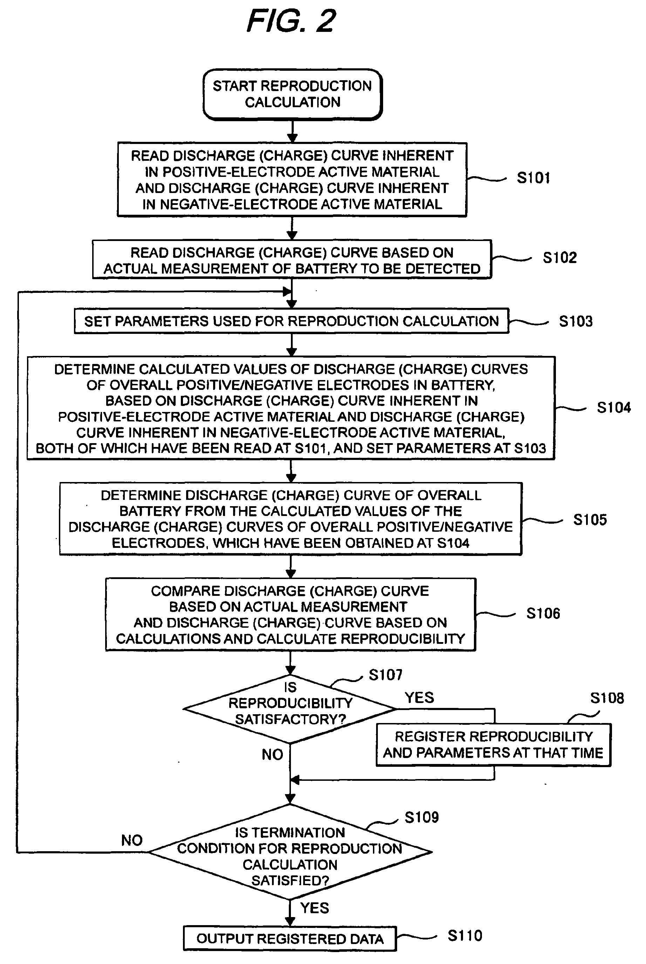

Fig. 2 is a flow chart showing a process (reproduction computing or calculating process) for determining or obtaining states (discharge curves) of positive and negative electrodes as internal information.

### (Step 101)

The arithmetic device 10 first reads a discharge curve inherent in a positive-electrode active material and a discharge curve inherent in a negative-electrode active material from the memory 11 (S101). Incidentally, these discharge curves have been stored in the memory 11 in advance.

Described specifically, the memory 11 stores the following therein as discharge curves:
(a) discharge curves represented in relationships vₚ(qₚ) and vₙ(qₙ) between densities of discharge quantities of electricity qₚ and qₙ [Ah g⁻¹] relative to positive and negative electrode active materials per unit mass and potentials vₚ and vₙ [V] respectively, (b) discharge curves represented in relationships dvₚ(qₚ)-dqₚ and dvₙ(qₙ)/dqₙ between above-mentioned qₚ and qₙ, and the rates of change in potential dvₚ/dqₚ and dv_{n/}dqₙ [V gAh⁻¹] respectively, and the like.

The above discharge curves of (a) and (b) can also be represented on the basis of a lithium composition ratio in active material materials, for example, y of LiyCoO₂ or y of LiyC₆. In such a case, the discharge curves are respectively represented in the following relationships:
(c) A relationship v(y) between a lithium composition ratio y inactive material materials and a potential v and
(d) A relationship dv(y)/dy between the lithium composition ratio y in the active material materials and the rate of change in potential dv/dy.

The advantages of using differential values as in the above discharge curves of (b) and (d) are as follows: The first reason is that since the potentials of the overall positive and negative electrodes do not depend on their effective active material masses, whereas the potential derivatives of the overall positive and negative electrodes are inversely proportional to their effective active material masses respectively, the displacement between a calculated value and an actually-measured value where incorrect effective active material masses are set is enlarged. The second reason is that although a voltage drop (voltage rise) ΔV = Rₛ × I due to an internal resistance is contained in an actually-measured voltage value Vₛ [V] assuming that the internal resistance of the lithium secondary battery is Rₛ [ Ω ] and the discharge current at the actual measurement is I [A], the undesirble influence of ΔV included in discharge curves can be reduced by using differential discharge curves.

### (Step 102)

Next, the arithmetic device 10 reads a discharge curve (called "discharge curve of overall battery based on actual measurement") actually measured from the detected battery (S102). Incidentally, a discharge curve corresponding to the type of discharge curve read at S101 is read here.

That is, when the discharge curves expressed in the vₚ(qₚ) and vₙ(qₙ) of the above (a) are read, the arithmetic device 10 reads a discharge curve represented in a relationship Vₛ(Qₛ) between a discharge quantity of electricity Qₛ [Ah] and a battery voltage Vₛ.

On the other hand, when the discharge curves expressed in the dvₚ(qₚ)/dqₚ and dv(qₙ)/dqₙ of the above (b) are read, the arithmetic device 10 reads a discharge curve represented in a relationship dVₛ(Qₛ)dQₛ between a discharge quatity Qₛ and the rate of change in battery voltage dVₛ/dQₛ [V Ah⁻¹].

Incidentally, the order of S101 and S102 may be set in reverse. The arithmetic device 10 may read these discharge curves as a data table based on measured data or may read the same as functions of q. When the discharge curves are read as the data table, values of q, v(q) and dv(q)/d_{q} are discrete. In this case, the values of v(q) and dv(q)/dq corresponding to an arbitrary q are determined by interpolation from other suitable q values of the read data table.

When each of the discharge curves is read as a function, values of v(q) and dv(q)/dq corresponding to arbitrary q are determined by calculating the function.

### (Step 103)

Next, the arithmetic device 10 sets parameters (called "correction parameters") for correcting the discharge curves obtained at S101 (S103).

Here, the correction parameters include four parameters which corresponding to a positive-electrode effective active material mass mₚ [g], a negative-electrode effective active material mass mₙ [g], an index Cₚ [Ah] indicative of a position relationship of a positive-electrode discharge curve, and an index Cₙ [Ah] indicative of a position relationship of a negative-electrode discharge curve.

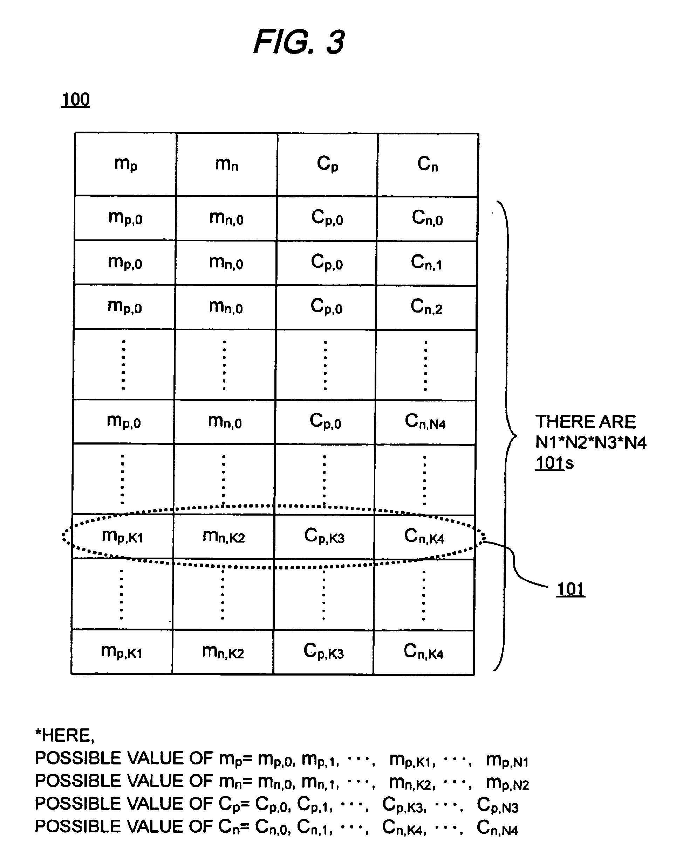

Fig. 3 shows a parameter table 100 that stores therein combinations of possible or available values of these parameters. The parameter table 100 has been stored in the memory 11 in advance. Upper and lower limits are included in the respective parameters, and the values thereof are set at predetermined intervals within the limits thereof. One combination of the four parameters (mₚ,mₙ,Cₚ and Cₙ) (called "parameter group") are stored in one record 101. All available parameter groups are stored in the parameter table 100. That is, when the four parameters (mₚ, mₙ, Cp and Cₙ) can respectively take the N1, N2, N3 and N4 kinds of values, records 101 each indicative of one of N1*N2*N3*N4 kinds of parameter groups exist in the parameter table 100.

The arithmetic device 10 selects one of non-selected records 101 in order from the head of the parameter table 100, extracts a parameter group stored in the record 101, and sets parameter values contained in the extracted parameter group as parameter values used in S104 of the following process.

### (Step 104)

Then, the arithmetic device 10 determines a discharge curve of the overall positive electrode in the battery and a discharge curve of the overall negative electrode therein, using the discharge curve inherent in the positive-electrode active material and the discharge curve inherent in the negative-electrode active material both of which have been read at S101 (S104). An example of a method for calculating the discharge curves herein will be explained below.

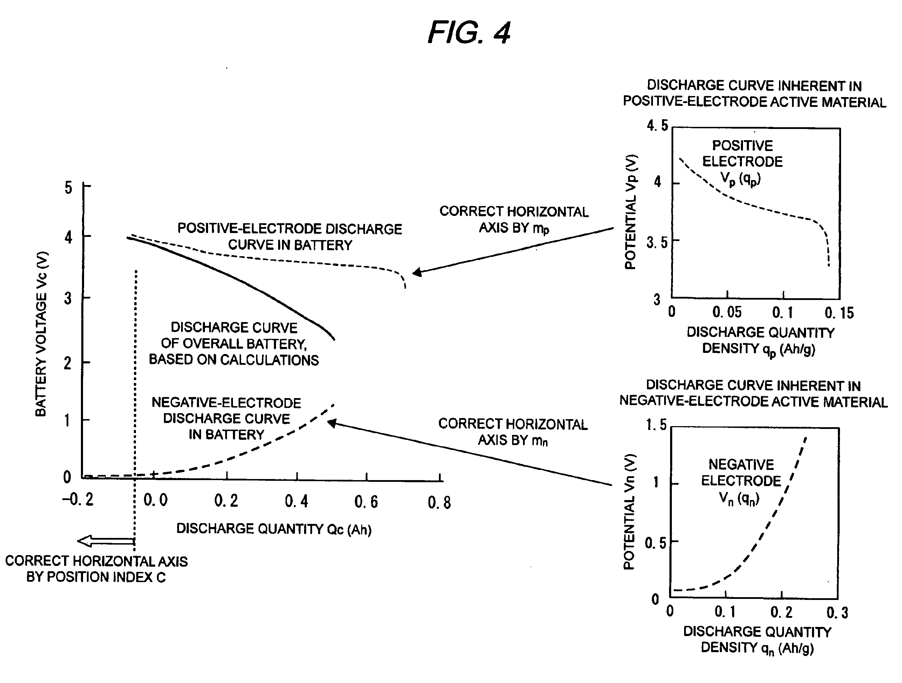

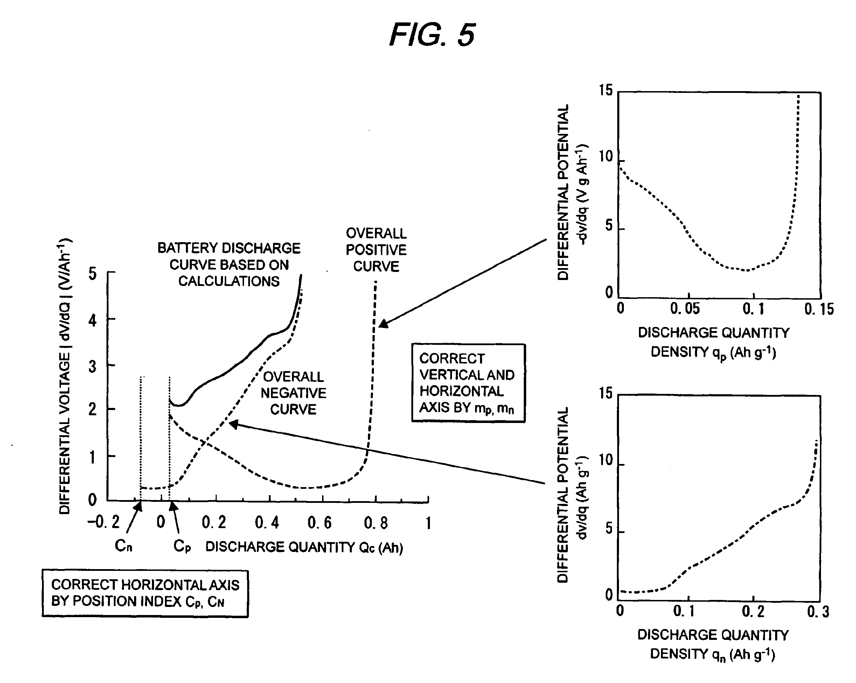

Assuming that the discharge quantities of electricity at the discharge curves of the overall positive and negative electrodes are Qₚ and Qₙ [Ah], they are given as Qₚ = qₚ × mₚ and Qₙ = qₙ × mₙ. Therefore, the arithmetic device 10 is operated as follows:
(1) When the arithmetic device 10 has read v(q) as the discharge curve inherent in the active material at S101 and read Vₛ(Qₛ) at S102 as shown in Fig. 4, it determines the relationship between a discharge quantity Qₚ and a potential Vₚ [V] of the overall positive electrode, i.e., a discharge curve of the overall positive electrode in the battery, using Vₚ(Qₚ) = vₚ(Qₚ/mₚ). Similarly, the arithmetic device 10 determines the relationship between a discharge quantity Qₙ and a potential Vₙ of the overall negative electrode, i.e., a discharge curve of the overall negative electrode in the battery, using Vₙ(Qₙ) = vₙ(Qₙ/mₙ).
(2) When the arithmetic device 10 has read dv(q)/dq as the discharge curve inherent in the active material at S101 and read dVₛ(Qₛ)/dQₛ at S102 as shown in Fig. 5 (that is, when a differential value is used), it determines the relationship between a discharge quantity of electricity Qₚ of the overall positive electrode and the rate of change in potential dVₚ/dQₚ [V Ah⁻¹] thereof, i.e., a discharge curve of the overall positive electrode, using following equation. ${dV}_{p} \left({Q}_{p}\right) / {dQ}_{p} = \left(1/{m}_{p}\right) \times {dV}_{p} \left({Q}_{p}/{m}_{p}\right) / {dq}_{p}$
Similarly, the arithmetic device 10 determines the relationship between a discharge quantity of electricity Qₙ and the rate of change in potential dVₙ/dQₙ [V Ah⁻¹]of the overall negative electrode, i.e., a discharge curve of the overall negative electrode, using following equation. ${dV}_{n} \left({Q}_{n}\right) / {dQ}_{n} = \left(1/{m}_{n}\right) \times {dV}_{n} \left({Q}_{n}/{m}_{n}\right) / {dq}_{n}$

### (Step 105)

Next, the arithmetic device 10 determines a calculated value (called "discharge curve of overall battery based on calculations") of a discharge curve of the overall battery, using the discharge curve of the overall positive electrode in the battery and the discharge curve of the overall negative electrode thereinside both of which have been obtained at S104, and the parameter values Cₚ and Cₙ set at S103 (S105).

Described roughly, the process of correcting the relationship of position between the discharge curves and superimposing them (adding them together) is performed here. One example of a calculating method will be explained below. Figs. 4 and 5 show a diagram for describing the calculating method.

Firstly, the arithmetic device 10 defines or fixes Q_{c} [Ah] as Q_{c}=Qₚ+Cₚ=Qₙ+Cₙ with respect to Qₚ and Qₙ using Cₚ and Cₙ set at S103. Here, Q_{c} means the discharge quantity of electricity at the "discharge curve of overall battery based on calculations". Next, the arithmetic device 10 defines or fixes the relationship between Q_{c} and a positive-electrode potential V'p inside the battery, i.e., a discharge curve of the overall positive electrode using V'ₚ(Q_{c})=Vₚ(Qₚ).

Similarly, the arithmetic device 10 fixes the relationship between Q_{c} and a negative-electrode potential V'ₙ inside the battery, i.e., a discharge curve of the overall negative electrode using V'ₙ(Q_{c})=Vₙ(Qₙ). Finally, the arithmetic device 10 determines the relationship between Q_{c} and a calculated value V_{c} of the battery voltage, i.e., the "discharge curve of overall battery based on calculations" using V_{c}(Q_{c})=V'ₚ(Q_{c})-V'ₙ(Q_{c}).

Incidentally, when the differential value is used, the arithmetic device 10 defines or fixes a discharge curve of the overall positive electrode in the battery with respect to Q_{c} using {dVₚ(Q_{c})/dQ_{c}}'=dVₚ(Qₚ)/dQₚ, fixes a discharge curve of the overall negative electrode in the battery with respect to Q_{c} using {dVₙ(Q_{c}}/dQ_{c}}'=dVₙ(Qₙ)/dQₙ, and determines the "discharge curve of overall battery based on calculations" using dV_{c}(Q_{c})/dQ_{c}={dVₚ(Q_{c})/dQ_{c}}'-{dVₙ(Q_{c})/dQ_{c}}'.

### (Step 106)

Next, the arithmetic device 10 compares the "discharge curve of overall battery based on actual measurement" obtained at S102 and the "discharge curve of overall battery based on calculations" determined at S105 and evaluates reproducibility (in other words, "correlation") (S106). As one example of its evaluating method, there is known the method of least squares. Described specifically, a parameter r indicative of the reproducibility is set as r=(Vₛ-V_{c}} 2 or r=(dVₛ/dQₛ-dV_{c}/dQ_{c}) 2 with respect to Qₛ, and the sum of r relative to Qₛ in a predetermined range is taken as R. The reproducibility is defined as satisfactory as R becomes smaller.

Incidentally, the present embodiment has explained S103 through S106 successively. However, the aim of processing these is to evaluate the reproducibility of the "discharge curve of overall battery based on calculations" with respect to the "discharge curve of overall battery based on actual measurement". It is possible to suitably change the order of their processing within the scope of this aim. For example, S104 and S105 can be performed simultaneously, and S105 and S106 can be promoted simultaneously with each other.

### (Step 107)

Next, the arithmetic device 10 determines whether the reproducibility is good (S107). As one example of its determining method, there is known, for example, a method of making its decision according to whether the above value R is smaller than a predetermined numerical value. When the value R is smaller than the predetermined value, it is determined that the reproducibility is satisfactory. Alternatively, the arithmetic device 10 determines whether the value R is smaller than any value R determined up to this point of time. If so, then the reproducibility may be determined to be satisfactory.

### (Step 108)

Only when it is determined that the reproducibility is satisfactory (Yes at S107), the arithmetic device 10 registers the parameter values (mₚ, mₙ, Cₚ, Cₙ) set at S103, the discharge curves (may be the discharge curves of the overall positive and negative electrodes after the position relationships have been corrected by Cₚ and Cₙ) of the overall positive and negative electrodes determined at S104, the "discharge curve of overall battery based on calculations" determined at S105, and the value R indicative of the reproducibility determined at S106 in a predetermined area of the memory 11 (S108).

### (Step 109)

Thereafter, the arithmetic device 10 determines whether the termination condition for reproduction calculation is satisfied (S109). As one example of the termination condition, may be mentioned, a case in which the calculation of all parameter groups (records 101) stored in the parameter table 100 has been completed, a case in which predetermined satisfactory reproducibility (i.e., value R less than or equal to the predetermined value) is obtained, or the like. When it is determined that the termination condition is not met (No at S109), the arithmetic device 10 returns to S103, where it extracts non-extracted parameter groups from the parameter table 100 and continues processing.

### (Step 110)

On the other hand, when it is determined that the termination condition is satisfied (Yes at S109), the arithmetic device 10 outputs the data registered at S108 via the output device 13 (S110).

At this time, the arithmetic device 10 may output all registered data. Alternatively, the arithmetic device 10 may select one typical data or plural data and output the same.

Described specifically, the arithmetic device 10 draws the discharge curve of the overall positive electrode and the discharge curve of the overall negative electrode (corresponding to the discharge curves of the overall positive and negative electrodes after the position relationships have been corrected by Cₚ and Cₙ) both of which have been registered, on the display as a discharge curve of the overall positive electrode of the detected battery and a discharge curve of the overall negative electrode thereof. The arithmetic device 10 draws the registered "discharge curve of overall battery based on calculations" on the display as a discharge curve of the overall detected battery. At this time, the "discharge curve of overall battery based on actual measurements" may be displayed for comparison. Incidentally, the discharge curves are not limited to graphic representation, but may be displayed using a table. The registered value R indicative of reproducibility may be displayed. The arithmetic device 10 is capable of accepting whether any of the data registered at S108 should be displayed, from a user via the input device 12.

The flow of Fig. 2 has been described above.

Incidentally, the arithmetic device 10 can also display the results of plural detected batteries simultaneously. For example, the processing of the flow shown in Fig. 2 is performed on the detected batteries respectively, thereby making it possible to simultaneously display and compare the data registered at S108.

The processing of the flow shown in Fig. 2 is performed based on a plurality of measured results of the same battery to be detected, so that information about an irreversible reaction of the inside of the battery can also be obtained. For example, the same detected battery is retained or stored for a given period of time without its discharge and battery voltages prior and subsequent to its storage are recorded. Further, the arithmetic device 10 acquires the actually-measured values of discharge curves prior to the retention (A) and subsequent to the retention (B). The processing of the flow shown in Fig. 2 is performed on the respective cases. In the respective cases, the above data are registered at S108.

### <Calculating the consumption of Lithium ion>

The arithmetic device 10 is capable of determining the amount of lithium ions consumed inside the battery by the irreversible chemical reaction during the retention period, using the correction parameters (mₚ, mₙ, Cₚ and Cₙ) in the data registered in this way.

One example of a calculation procedure will be shown below. Firstly, (Cₙ-Cₚ) assumes (Cₙ-Cₚ)=mₚ×qₚ - mₙ×qₙ in accordance with Qₚ=mₚ×qₚ, Qₙ=mₙ×qₙ and Qₚ=Qₙ+Cₙ-Cₚ. Thus, it can be made approximate to the following equation. $Δ ⁢ \left({C}_{n}-{C}_{p}\right) = \left({q}_{p}⁢{Δm}_{p}-{q}_{n}⁢{Δm}_{n}\right) + \left({m}_{p}⁢{Δq}_{p}-{m}_{n}⁢{Δq}_{n}\right)$
According to the approximation of the equation (1), when a change in the battery voltage during the retention is small, the amount of consumption of lithium ions by the irreversible chemical reaction is obtained from the following equation:

$The amount of consumption of lithium ions by irreversible chemical reaction = Δ ⁢ \left({C}_{n}-{C}_{p}\right) - \left({q}_{p}⁢{Δm}_{p}-{q}_{n}⁢{Δm}_{n}\right)$ It is possible to acquire Cₙ, Cₚ, mₚ and mₙ prior and subsequent to the retention from the data registered at S108. By performing reproduction calculations , qₚ and qₙ corresponding to the battery voltages at the start time of retention and the end time of retention can be acquired, and the average value of qₚ and qₙ during the retention period can be acquired. Substituting these into the equation (2) makes it possible to yield the amount of consumption of lithium ions by the irreversible chemical reaction during the retention period. According to the approximation of the equation (1), when a change in the amounts of effective active material masses during the retention is small, the consumption of lithium ions by the irreversible chemical reaction is obtained from the following equation: $Consumption of lithium ions by irreversible chemical reaction = \left({m}_{p}⁢{Δq}_{p}-{m}_{n}⁢{Δq}_{n}\right)$
It is possible to acquire Cₙ, Cₚ, mₚ and mₙ and qₚ and qₙ corresponding to the battery voltages at the start time of retention and the end time of retention from the data registered at S108. Acquiring the average value of mₚ and mₙ during the retention period and substituting these into the equation (3) makes it possible to yield the amount of consumption of lithium ions by the irreversible chemical reaction during the retention period. Incidentally, data to be outputted actually may be one of the so-obtained values or plural thereof.

Further, the arithmetic device 10 is capable of performing operations such as various status decisions, a change of the battery use condition, etc. , on the basis of the discharge curves of the positive and negative electrodes at the detected battery and the combinations of the correction parameters, which have been obtained as the result of processing of the flow shown in Fig. 2. For example, operations such as the resetting of an upper limit of a battery voltage can be performed on a battery control device with a high degree of accuracy so as to prevent the potential of the positive-electrode active material from being over predetermined threshold. Several operation examples will be cited below.

### <Operation example 1>

When any of, for example, (1) the positive-electrode effective active material mass mₚ is 70 percent or less of an initial value, (2) the negative-electrode effective active material mass mₙ is 70 percent or less of an initial value, and (3) the absolute value of the amount of change in position index (Cₙ-Cₚ) from an initial value is 20 percent or more of a discharge capacity at the measurement thereof is reached, the arithmetic device 10 outputs a signal for recommending the replacement of a detected battery via the output device 13. Incidentally, the threshold value used for determination can be defined for every system depending on the materials for active materials that constitute a battery, the ratio between the active materials of the positive and negative electrodes at the design of the battery, required performance and the like.

### <Operation example 2>

When the potential of the positive or negative electrode in a battery usable range defined by the upper-limit and lower-limit voltages of a detected battery falls outside a predetermined range, the arithmetic device 10 is capable of newly setting an upper-limit or lower-limit voltage of the battery in such a manner that the potential of the positive or negative electrode falls within the predetermined range.

The example will be described concretely. After the processing of the flow shown in Fig. 2 is performed, the shapes of the discharge curve of the overall positive electrode in the battery and the discharge curve of the overall negative electrode therein and their position or physical relationships are accurately grasped at the stage of reproduction of the discharge curves. Thus, assuming that, for example, the upper-limit voltage (e.g., 4.1V vs. Li/Li⁺ potential at which a reaction occurs) at the use of the battery has been defined, the potentials of the positive and negative electrodes corresponding to the upper-limit voltage are respectively known.

The shapes of the discharge curve of the overall positive electrode in the battery and the discharge curve of the overall negative electrode therein, and their position relationships change with the deterioration of the battery. Therefore, there is a case where although the potential of the positive electrode corresponding to the upper-limit voltage 4.1V of the battery is 4.2V in the initial state of the battery, the potential of the positive electrode corresponding to the upper-limit voltage 4.1V of the battery assumes 4.3V as its deterioration progresses. On the other hand, the properly-usable potential ranges respectively exist in the materials for the positive and negative electrodes, and the progress of its deterioration becomes fast outside the potential ranges.

From the above viewpoint, the arithmetic device 10 defines the following as specific setting methods.
(1) A use for working potential (which ranges from, for example, 3. 7V to 4. 2V) for the positive electrode is determined in advance.
(2) A working potential (which ranges from 0.05V to 1. 3V, for example) for the negative electrode is determined.
(3) The range of a discharge quantity of electricity Q at which the working potential for the positive electrode is satisfied is determined at the discharge curve of the overall positive electrode obtained by the reproduction calculation.
(4) Similarly, the range of a discharge quantity of electricity Q corresponding to the working potential for the negative electrode is determined at the discharge curve of the overall negative electrode.
(5) A portion where the ranges determined at the above (3) and (4) overlap is determined as a new battery usage or available range.
(6) Further, a battery voltage corresponding to the range of the discharge quantity of electricity Q determined at the above (5) is determined from the "discharge curve of overall battery based on calculations" obtained by the reproduction calculation.
(7) The maximum and minimum values of the voltage obtained at the above (6) are respectively defined as new upper-limit and lower-limit voltages.

### <Operation example 3>

When the potential of the negative electrode in a calculated fully-charged state falls within a predetermined range, the arithmetic device 10 may give a warning about the risk of an internal short-circuit to a battery to be detected. It will be explained specifically. Lithium ions are absorbed into a negative-electrode active material upon charging. When, however, the lithium ions are caused to absorb therein beyond a critical amount, they are not absorbed therein, but precipitated on the surface of the active material as a lithium metal. Since the metal lithium is precipitated as a needle-like crystal at this time, it penetrates through a separator that separates the positive and negative electrodes from each other to cause an internal short-circuit as the case may be.

On the other hand, the amount of absorption of the lithium ions of the negative-electrode active material per unit mass, and the potential of the negative electrode are placed in a one-to-one relationship. Thus, if the negative-electrode potential (determined from the reproduction calculation) corresponding to the upper-limit voltage (= fully-charged state) of the battery is smaller than a negative-electrode potential corresponding to the critical amount, then the precipitation of the lithium metal on the surface of the negative electrode is suspected in the fully-charged state.

From the above description, the arithmetic device 10 performs the following:
(1) It decides a negative-electrode potential (0.03V, for example) for giving warning, in advance.
(2) It determines the potential of the negative electrode corresponding to the upper-limit voltage of the battery (4.1V, for example) at the discharge curve of the negative electrode obtained by the reproduction calculation.
(3) When the potential obtained at the above (2) is smaller than the potential decided at the above (1), it gives warning.

### <Operation example 4>

The arithmetic device 10 is also capable of calculating and outputting the remaining lifetime of a battery to be detected. It will be explained specifically. First, the discharge capacity of the battery is determined according to (1) the discharge curve vₚ(qₚ) inherent in the positive-electrode active material, (2) the discharge curve vₙ(qₙ) inherent in the negative-electrode active material, (3) the effective positive-electrode active material mass mₚ, (4) the effective negative-electrode active material mass mₙ, (5) the relationship of position between the positive and negative electrodes (Cₙ-Cₚ), and (6) the upper-limit voltage Vₘₐₓ and lower-limit voltage Vₘᵢₙ. Of these, the values of the above (1), (2) and (6) can be determined as described in the above embodiment.

Thus, if it is possible to determine to which function the values of the above (3), (4) and (5) correspond with respect to a period of use t, an environmental temperature T, a retention voltage V, a load P and the like, respectively, a discharge capacity Q (t, T, V, P, ...) of the battery can be calculated by combinations of the values of the above (1) through (6).

A method of calculating the discharge curve of the battery, the discharge capacity thereof and the remaining lifetime thereof where the functional forms of the above (3), (4) and (5) are given will first be explained.

The above-mentioned Qₚ can be used here as a calculational discharge quantity of electricity at the discharge curve of the battery. In doing so, a battery discharge curve V_{c}(Qₚ) obtained by calculation can be written as V_{c}(Qₚ)=Vₚ(Qₚ)-Vₙ(Qₙ), using the discharge curve Vₚ(Qₚ) of the overall positive electrode in the battery and the discharge curve Vₙ(Qₙ) of the overall negative electrode therein.

Here, Qₚ and Qₙ are given as Qₚ=mₚ×qₚ, Qₙ=mₙ×qₙ and Qₙ=Qₚ-(Cₙ-Cₚ) as mentioned above. Further, Vₚ(Qₚ) and Vₙ(Qₙ) are respectively given as Vₚ(Qₚ)=vₚ(Qₚ/mₚ) and Vₙ(Qₙ)=Vₙ(Qₙ/mₙ) as mentioned above. Thus, the calculated value of the discharge curve of the battery assumes V_{c}(Qₚ)=Vₚ(Qₚ/mₚ)-vₙ({Qₚ-(Cₙ-Cₚ)}/mₙ). If Q_{p,min} and Q_{p,max} that satisfy V_{c}(Q_{p,min})=Vₘₐₓ, V_{c}(Q_{p,max})=Vₘᵢₙ at the calculated value of the discharge curve of the battery are determined, then the discharge capacity W of the battery is obtained by W=Q_{p,max}-Q_{p,min}.

The above calculations are performed on various periods of use t and their battery discharge capacities W(t) are determined. t_{end} that satisfies W(t_{end})=W_{end} with respect to the capacity W_{end} at the end of the battery lifetime results in the lifetime of the battery. Assuming that the present period of use is tₒ, the remaining lifetime is given as (t_{end}-tₒ).

Next, amethod for determining to which function the values of the above (3), (4) and (5) respectively correspond with respect to a period of use t, an environmental temperature T, a retention voltage V, a load P and the like will be explained.

Simple function forms may be decided as the above (3), (4) and (5). For example, the arithmetic device 10 represents the effective positive-electrode active material mass and the effective negative-electrode active material mass as, for example, m(t)=m(0)×exp(-t/τ) (where τ: constant), represents the position or physical relationship between the positive and negative electrodes as, for example, (Cₙ-Cₚ)=A×√ t(where A: constant).

Alternatively, the arithmetic device 10 represents the above (3), (4) and (5) in the following manner, for example.

As to (3) the effective positive-electrode active material mass mₚ, the rate of change in time mₚ(t) dmₚ/dt is represented as a polynominal expression of mₚ itself, i.e., dmₚ/dt=Σₙ An mₚ ⁿ (where n: integer, and Aₙ: amount determined uniquely with respect to the battery use conditions T, V, P, etc. without depending on the period of use t). Here, Aₙ may be stored in the memory 11 of the internal information detecting apparatus 1 as a function of T, V, P, etc.

Since the value of mₚ at to at which of the battery is detected can be determined as described in the above embodiment, the value of m(t) at t≥tₒ can be estimated by combining the above polynominal expression and an initial condition mₚ(tₒ).

The arithmetic device 10 can also determine the values of (4) and (5) in like manner.

Alternatively, the arithmetic device 10 represents the above (3), (4) and (5) in the following manner, for example.

As to (3) the effective positive-electrode active material mass mₚ, the arithmetic device 10 defines or fixes a boundary condition in addition to a differential equation of mₚ in the polynominal expression and the initial condition, determines a solution of mₚ in the polynominal expression and represents mₚ as a function of the period of use t and the battery use conditions T, V, P, etc., thereby making it possible to determine the value of mₚ directly. At this time, the arithmetic device 10 may perform the operation of determining the solution of mₚ. Alternatively, the arithmetic device 10 may store a solution determined in advance in the memory 11 and read it.

As the boundary condition, for example, the following condition may be used assuming that mₚ becomes a value m_{p∞} which does not depend on the period of use t with respect to a sufficient long period of use t_{∞}. $lim \left(\to ∞\right) ⁢ {m}_{p} \left(t\right) = \to {m}_{p∞}$
Further, m_{p∞} may be the function of the battery use conditions T, V, P, etc.

The arithmetic device 10 can also determine the values of the above (4) and (5) in like manner.

Further, it may perform processing as mentioned below in consideration of the case where the use condition of a secondary battery is changed during a period of its use.

The arithmetic device 10 represents the values of the above (3), (4) and (5) at the time that the use condition of the secondary battery is changed during the period of its use, in the following manner, for example.

As to the use conditions of the secondary battery after the above to, for example, the battery is used under a use condition A up to a period of its use t₁, whereas it is used under a use condition B between periods of its use t₁ and t₂.

As to (3) the effective positive-electrode active material mass mₚ, the value mₚ(tₒ) of the above mₚ at the to can be determined by the status detecting method. The value of the above mₚ between the use periods tₒ and t₁ is determined in the following manner.

A coefficient corresponding to the use condition A is used in the polynominal expression indicative of the rate of change in mp. The value mₚ(t) of the mₚ between the use periods tₒ and t₁ is calculated using a numerical calculation of the polynominal expression or an analytical solution of the differential equation in the polynominal expression.

The value mₚ(t₁) of the mₚ at the t₁ is determined in this way. The value of the mₚ between the use periods t₁ and t₂ can be determined in like manner with mₚ(t₁) corresponding to the final value of the mₚ between the use periods tₒ and t₁ as an initial value.

It is possible to determine the value of the mₚ where the use condition for the secondary battery is changed during the period of use, by this procedure. Even when the use condition is changed twice or more, the arithmetic device is capable of determining the relationship mₚ(t) of the period of use t of the above mₚ in a procedure similar to the above. The arithmetic device 10 can determine even the (4) and (5) in like manner.

The several operation examples have been explained above.

Incidentally, there are cited two as the reason why the position indices C are used as the parameters upon reproduction calculation. One thereof is that the position index is used to decide the position or physical relationship between the discharge curve of the positive electrode and the discharge curve of the negative electrode at the time that they are superimposed on each other. Another one thereof is that the position index is used to cause a zero point of Q_{c} of a discharge curve obtained by overlap calculation and a zero point of Qₛ of a discharge curve based on actually measured values to coincide each other. Thus, at least two position indices Cₚ and Cₙ may desirably be used for reproduction calculation from the viewpoint of reproducibility.

However, the number of the position indices C can also be set to one to reduce a calculation load. In this case, the process of allowing the zero points of the discharge quantities of electricity Q of the "discharge curve of overall battery based on actual measurement" and "discharge curve of overall battery based on calculations" to coincide with each other may be conducted immediately before the process S106.

Described specifically, the arithmetic device 10 determines a battery voltage V_{ref} and a discharge quantity of electricity Q_{ref} [Ah] in advance both of which are taken as the references, and determines discharge quantities of electricity Qₛ₀ and Q_{c0} [Ah], corresponding to the V_{ref} [V] on the "discharge curve of overall battery based on actual measurement" and "discharge curve of overall battery based on calculations", respevtively. The arithmetic device 10 adds a constant (Q_{ref}-Qₛ₀) to the discharge quantity of electricity Qₛ of the "discharge curve of overall battery based on actual measurement" and adds a constant (Q_{ref}-Q_{c0}) to the discharge quantity of electricity Q_{c} of the "discharge curve of overall battery based on calculations", thereby unifying the discharge quantities of electricity of both discharge curves.

Alternatively, as another method, the arithmetic device 10 defines or fixes a discharge quantity of electricity Q_{ref} taken as the reference in advance. First, the arithmetic device 10 determines a battery voltage Vₛ₀ or differential voltage (dV/dQ)ₛ₀ corresponding to Q_{ref} at the "discharge curve of overall battery based on actual measurements". Next, the arithmetic device 10 determines a discharge quantity Q_{c1} for giving Vₛ₀ or (dV/dQ)ₛ₀ at the " discharge curve of overall battery based on calculations" and adds a constant (Q_{ref}-Q_{c1}) to the discharge quantity of electricity Q_{c} of "discharge curve of overall battery based on calculations", thereby unifying the discharge quantities of both discharge curves.

The present invention is not limited to the above embodiment.

In the above embodiment, the data (discharge curve inherent in positive-electrode active material, discharge curve inherent in negative-electrode active material and parameter table 100) described as being stored in the memory 11 of the internal information detecting apparatus 1 may be stored in a memory (not shown) of a device configured integrally with a battery to be detected. That is, at S101 of Fig. 2, the arithmetic device 10 acquires a discharge curve inherent in the positive-electrode active material and a discharge curve inherent in the negative-electrode active material from the memory on the detected battery side. At S103, the arithmetic device 10 acquires a parameter group from the memory on the detected battery side. If done in this way, it is then not necessary to store data inherent in the detected battery into the memory 11 of the internal information detecting apparatus 1.

The internal information detecting method according to the present invention can be applied to all positive-electrode active materials and all negative-electrode active materials, and the combinations of all positive-electrode active materials and all negative-electrode active materials without limiting materials.

Further, it can be applied to a power system of an electric vehicle. In this case, a main body of the electric vehicle has a lithium secondary battery and a memory section or portion. A behavior at night charging or charge-discharge behaviors at the charge-discharge, which are aimed at applying the present invention, may preferably be stored in the memory portion. The internal information detecting apparatus 1 referred to above is disposed in a service center. Upon vehicle checks, internal information of the lithium secondary battery is detected by the processing of the flow shown in Fig. 2.

The present invention can be applied to an industrial or household storage battery system. In this case, a storage system main body has a lithium secondary battery and a memory section or portion. A behavior at night charging or charge-discharge behaviors at the charge-discharge, which are aimed at applying the present invention, may desirably be stored in the memory portion. The internal information detecting apparatus 1 referred to above is held by a worker or operator who performs a check operation. Upon a check, internal information of the lithium secondary battery is detected by the processing of the flow shown in Fig. 2. Alternatively, the internal information detecting apparatus 1 may be connected to the storage system on a regular basis in communication with the same and thereby detect internal information of the lithium secondary battery.

According to the present invention as described above, the circumstances of charge or discharge curves of an overall positive electrode in a secondary battery and charge or discharge curves of an overall negative electrode therein can be recognized without disassembling the battery. Thus, it is possible to specify or identify a factor of battery deterioration without disassembling the battery and make a high-precision lifetime decision. Further, according to the present invention, the suitable usable range of a deteriorated battery can be judged with a high degree of accuracy by application of the result of reproduction calculations, and the amount of reduction in charge or discharge reaction species can be acquired without disassembling the batteries.

## Claims

1. A method for detecting internal information of the situation of a positive electrode in a secondary battery and the situation of a negative electrode in a secondary battery, comprising:
a first step for acquiring charge and/or discharge curves inherent in a positive electrode material and charge and/or discharge curves inherent in a negative electrode material, as reference data, and acquiring charge and/or discharge curves of a detected battery as actually-measured values;
a second step for determining charge and/or discharge curves of a positive electrode in the detected battery and charge and/or discharge curves of a negative electrode therein, using the charge and/or discharge curves inherent in the positive electrode material, the charge and/or discharge curves inherent in the negative electrode material, the charge and/or discharge curves of the detected battery as the actually-measured values, and predetermined correction parameters; and
a third step for outputting a result of the second step,
**characterized in that**
the predetermined correction parameters in the second step include four parameters which correspond to a positive-electrode effective active material mass mₚ [g], a negative-electrode effective active material mass mₙ [g], an index Cₚ [Ah] indicative of a position relationship of a positive-electrode discharge curve, and an index Cₙ [Ah] indicative of a position relationship of a negative-electrode discharge curve, that
the second step includes:
a correlation calculating step for correcting the charge and/or discharge curves inherent in the positive electrode material and the charge and/or discharge curves inherent in the negative electrode material, using correction parameters for correcting positive and negative active material masses that contributes to charge and/or discharge and thereby determining charge and/or discharge curves of an overall positive electrode and charge and/or discharge curves of an overall negative electrode, correcting a position relationship between the charge and/or discharge curves of the overall positive electrode and the charge and/or discharge curves of the overall negative electrode, using correction parameter for correcting a position relationship between positive and negative charge and/or discharge curves and further superimposing the charge and/or discharge curves of the two thereby to determine charge and/or discharge curves of overall battery based on calculations of the overall battery, and determining a correlation between the charge and/or discharge curves of the overall battery based on the calculations and the charge and/or discharge curves of the overall battery based on the actual measurement;
a correction parameter identifying step for identifying correction parameters where the correlation becomes high in the correlation calculating step; and
an estimating step for estimating the charge and/or discharge curves of the overall positive electrode and the charge and/or discharge curves of the overall negative electrode at which the position relationship are corrected using correction parameters identified in the correction parameter identifying step, as the charge and/or discharge curves of the overall positive electrode in the secondary battery and the charge and/or discharge curves of the overall negative electrode in the secondary battery, and that
in the third step, at least one of the charge and/or discharge curves of the positive electrode, the charge and/or discharge curves of the negative electrode and the correction parameters used for calculation, which have been determined at said second step, are output.

2. The method according to claim 1, wherein the charge and/or discharge curves indicate relationships between charge and/or discharge quantities of electricity and the amounts of changes in voltages relative to the amounts of changes in the charge and/or discharge quantities of electricity.

3. The method according to claim 1, further including the step of outputting a signal for recommending the replacement of the detected battery where any of a used potential range of the charge and/or discharge curves of the positive electrode, a used potential range of the charge and/or discharge curves of the negative electrode and the correction parameter used in the calculation, which have been determined in the second step, falls within a predetermined range.

4. The method according to claim 1, further including the step of, when the potential of the positive or negative electrode in a battery usage range defined by upper-limit and lower-limit voltages of the detected battery falls outside a predetermined range at the charge and/or discharge curves of the positive electrode and the chargerdischarge curves of the negative electrode, which have been determined in the second step, the upper-limit or lower-limit voltage of the detected battery is newly set in such a manner that the potential of the positive or negative electrode falls within the predetermined range.

5. The method according to claim 1, further including the step of giving a warning about the risk of an internal short-circuit to the detected battery where the potential of the negative electrode lying in a fully-charged state calculated using the charge and/or discharge curves of the positive electrode and the charge and/or discharge curves of the negative electrode, which have been determined in the second step falls within a predetermined range.

6. The method according to claim 1, further including the step of calculating and outputting the amount of a reduction in charge and/or discharge reaction species in the detected battery using the charge and/or discharge curves of the positive electrode and the charge and/or discharge curves of the negative electrode, which have been determined in the second step.

7. The method according to claim 1, further including the step of calculating and outputting the remaining lifetime of the detected battery using the charge and/or discharge curves of the positive electrode and the charge and/or discharge curves of the negative electrode, which have been determined in the second step.

8. The method according to claim 1, further including the steps of, using the fact that the value of the correction parameter used in the second step is set as an initial value, the rate of change in the correction parameter with time is represented by a polynominal expression of the correction parameter per se, and the values of coefficients of terms in the polynominal expression are determined from a function or a table with at least a temperature and a battery voltage or an electrode potential as variables, determining at least one value of the correction parameters with respect to a given time of use of the secondary battery and determining a discharge capacity or a charge capacity of the secondary battery using the correction parameters determined in said procedure, and of, when the so-obtained charge or discharge capacity coincides with a reference value determined in advance, defining the time of use thereof as a lifetime of the detected battery and determining the lifetime or the remaining lifetime determined from the lifetime.

9. The method according to claim 8, which includes a procedure of, when a correction parameter x with respect to the given use time of the secondary battery is determined, defining at least one combination of a first period during which the secondary battery is used under a first condition, and a second period which follows the first period continuously on a time basis and during which the second battery is used under a second condition; calculating an initial value x1 of the correction parameter x in the first period, and calculating a final value x2 of the correction parameter x in the first period, using the polynominal expression corresponding to the first condition or a solution thereof; and calculating a final value x3 of the correction parameter in the second period, using x2, which is the final value of x in the first period, as an initial value of the correction parameter in the second period and using the polynominal expression corresponding to the second condition or a solution thereof.

10. An apparatus for detecting internal information of the situation of a positive electrode in a secondary battery and the situation of a negative electrode a secondary battery, comprising:
first means for acquiring, as reference data, charge and/or discharge curves inherent in a positive electrode material and charge and/or discharge curves inherent in a negative electrode material and acquiring charge and/or discharge curves of a detected battery as actually-measured values;
second means for determining charge and/or discharge curves of a positive electrode in the detected battery and charge and/or discharge curves of a negative electrode therein, using the charge and/or discharge curves inherent in the positive electrode material, the charge and/or discharge curves inherent in the negative electrode material, the charge and/or discharge curves of the detected battery as the actually-measured values, and predetermined correction parameters; and
third means for outputting a result of the second step,
**characterized in that**
the predetermined correction parameters in the second step include four parameters which correspond to a positive-electrode effective active material mass mp [g], a negative-electrode effective active material mass mₙ [g], an index Cₚ [Ah] indicative of a position relationship of a positive-electrode discharge curve, and an index Cₙ [Ah] indicative of a position relationship of a negative-electrode discharge curve, that the third means all adapted to output
one of the charge and/or discharge curves of the positive electrode, the charge and/or discharge curves of the negative electrode and the correction parameters used in the calculation, which have been determined by the second means, and that
the second means includes:
correlation calculating means for correcting the charge and/or discharge curves inherent in the positive electrode material and the charge and/or discharge curves inherent in the negative electrode material using a first correction parameter for correcting positive and negative active material masses that contribute to charge and/or discharge and thereby determining charge and/or discharge curves of the overall positive electrode and charge and/or discharge curves of the overall negative electrode, correcting a position relationship between the charge and/or discharge curves of the overall positive electrode and the charge and/or discharge curves of the overall negative electrode using correction parameters for correcting the position relationship between positive and negative charge and/or discharge curves and further superimposing both the charge and/or discharge curves on one another thereby to determine charge and/or discharge curves of the overall battery based on calculations of the overall battery, and determining a correlation between the charge and/or discharge curves of the overall battery based on the calculations and the charge and/or discharge curves of the overall battery based on the actual measurement;
correction parameter identifying means for identifying correction parameters where the correlation becomes high in the correlation calculating step; and
estimating means for estimating the charge and/or discharge curves of the overall positive electrode and the charge and/or discharge curves of the overall negative electrode at which the position relationship are corrected using the correction parameters identified in the correction parameter identifying means, as the charge and/or discharge curves of the overall positive electrode in the secondary battery and the charge and/or discharge curves of the overall negative electrode in the secondary battery, and that
the third means for outputting at least a result of the second step are adapted to output at least one of the charge and/or discharge curves of the positive electrode, the charge and/or discharge curves of the negative electrode and the correction parameters used for calculation, which have been determined at said second step.

11. The apparatus according to claim 10, wherein, using the fact that the value of the correction parameter used in the second means is set as an initial value, the rate of change in the correction parameter with time is represented by a polynominal expression of the correction parameter per se, and the values of coefficients of respective terms in the polynominal expression are determined from a function or a table with at least a temperature and a battery voltage or an electrode potential as variables, at least one value of the correction parameter is determined with respect to a given time of use of the secondary battery, and a discharge capacity or a charge capacity of the secondary battery is determined using at least one of the correction parameters determined in the procedure, and
wherein, when the so-obtained charge or discharge capacity coincides with a reference value determined in advance, the time of use thereof is defined as a lifetime of the detected battery and the lifetime or the remaining lifetime determined from the lifetime is determined.

## Patentansprüche

1. Verfahren zur Erkennung interner Information des Zustandes einer positiven Elektrode in einer Sekundärbatterie und des Zustandes einer negativen Elektroden in einer Sekundärbatterie umfassend:
einen ersten Schritt zur Aufnahme von Lade- und/oder Entladekurven, die in einem positiven Elektrodenmaterial inhärent sind, als Referenzdaten und zur Aufnahme von Lade- und/oder Entladekurven einer detektierten Batterie als tatsächlich gemessene Werte;
einen zweiten Schritt zur Bestimmung von Lade- und/oder Entladekurven einer positiven Elektrode in der detektierten Batterie und Lade- und/oder Entladekurven einer negativen Elektrode darin unter Verwendung der Lade- und/oder Entladekurven, die in dem positiven Elektrodenmaterial inhärent sind, der Lade- und/oder Entladekurven, die in dem negativen Elektrodenmaterial inhärent sind, Lade- und/oder Entladekurven der detektierten Batterie als tatsächlich gemessene Werte, und vorgegebene Korrekturparameter; und
einen dritten Schritt zur Ausgabe eines Ergebnisses des zweiten Schritts,
**dadurch gekennzeichnet, dass**
die vorgegebenen Korrekturparameter in dem zweiten Schritt vier Parameter umfassen, die einer effektiven, aktiven Materialmasse mₚ[g] einer positiven Elektrode, einer effektiven, aktiven Materialmasse mₙ[g] einer negativen Elektrode, einem Index Cₚ[Ah], der eine positive Beziehung einer Entladekurve einer positiven Elektrode anzeigt, und einem Index Cₙ[Ah] entsprechen, der eine positive Beziehung der Entladekurve der negativen Elektrode anzeigt,
dass der zweite Schritt umfasst,
einen Korrekturberechnungsschritt zum Korrigieren der Lade- und/oder Entladekurven, die in dem positiven Elektrodenmaterial inhärent sind, und der Lade- und/oder Entladekurven , die in dem negativen Elektrodenmaterial inhärent sind, unter Verwendung von Korrekturparameter, um positive und negative, aktive Materialmassen, die zu der Ladung oder Entladung beitragen, zu bestimmen und dadurch Lade- und/oder Entladekurven einer insgesamt positiven Elektroden und der Lade- und/oder Entladekurven einer insgesamt negativen Elektrode zu bestimmen, Korrigieren einer positiven Beziehung zwischen den Lade- und/oder Entladekurven der insgesamt positiven Elektrode und der Lade- und/oder Entladekurven der insgesamt negativen Elektrode unter Verwendung von Korrekturparametern, um eine positive Beziehung zwischen den positiven und negativen Lade- und/oder Entladekurven zu korrigieren und ferner die Lade- und/oder Entladekurven der beiden übereinander zu legen, um dadurch die Lade- und/oder Entladekurven der gesamten Batterie auf der Grundlage von Berechnungen der Gesamtbatterie zu bestimmen, und Bestimmung einer Korrelation zwischen den Lade- und/oder Entladekurven der Gesamtbatterie auf der Basis der Berechnungen und der Lade- und/oder Entladekurven der Gesamtbatterie basierend auf der tatsächlichen Messung;
einen Korrekturparameter-Identifizierungsschritt zur Identifizierung der Korrekturparameter, wobei die Korrelation in dem Korrelationsberechnungsschritt hoch wird; und
einen Abschätzungsschritt, um die Lade- und/oder Entladekurven der insgesamt positiven Elektrode und die Lade- und/oder Entladekurven der insgesamt negativen Elektrode abzuschätzen, bei der die positiven Beziehungen unter Verwendung der Korrekturparameter korrigiert werden, die in dem Korrekturparameter-Identifizierungsschritt identifiziert wurden, als Lade- und/oder Entladekurven der insgesamt positiven Elektrode in der Sekundärbatterie und der Lade- und/oder Entladekurven der insgesamt negativen Elektrode in der Sekundärbatterie, und dass
in dem dritten Schritt wenigstens eines aus den Lade- und/oder Entladekurven der positiven Elektrode, der Lade- und/oder Entladekurven der negativen Elektrode und die für die Berechnung verwendeten Parameter, die in dem zweiten Schritt bestimmt worden sind, ausgegeben werden.

2. Verfahren nach Anspruch 1, worin die Lade- und/oder Entladekurven die Beziehungen zwischen den Lade- und/oder Entlademengen an Elektrizität und die Menge an Ladung in Volt relativ zu den Ladungsmengen in der Lade- und/oder Entlademenge an Elektrizität anzeigen.

3. Verfahren nach Anspruch 1, ferner umfassend den Schritt der Ausgabe eines Signals, um den Ersatz der detektierten Batterie zu empfehlen, wenn eines aus dem benutzten Potentialbereich der Lade- und/oder Entladekurven der positiven Elektrode, der benutzten Potentialbereich der Lade- und/oder Entladekurven der negativen Elektroden und den in der Berechnung benutzten Korrekturparameter, die in dem zweiten Schritt bestimmt worden sind, in einen vorgegebenen Bereich fällt.

4. Verfahren nach Anspruch 1, ferner umfassend einen Schritt, bei dem, wenn das Potential der positiven oder negativen Elektrode in einem Batteriebenutzungsbereich, der durch eine Spannungsobergrenze und eine Spannungsuntergrenze der detektierten Batterie definiert ist, au-βerhalb eines vorgegebenen Bereichs an den Lade- und/oder Entladekurven der positiven Elektrode und den Lade- und/oder Entladekurven der negativen Elektrode liegt, die in dem zweiten Schritt bestimmt worden sind, die Spannungsobergrenze oder Spannungsuntergrenze der detektierten Batterie neu in einer solchen Weise eingestellt wird, dass das Potential der positiven oder negativen Elektrode in einen vorgegebenen Bereich fällt.

5. Verfahren nach Anspruch 1, ferner umfassend den Schritt, dass eine Warnung über das Risiko einer internen Kurzschlussschaltung bei der detektierten Batterie gegeben wird, wenn das Potential der negativen Elektrode in einem voll aufgeladenen Zustand ist, was berechnet wird unter Verwendung der Lade- und/oder Entladekurven der positiven Elektrode, und der Lade- und/oder Entladekurven der negativen Elektrode, die in dem zweiten Schritt bestimmt worden sind, in einem vorgegebenen Bereich fallen.

6. Verfahren nach Anspruch 1, ferner umfassend den Schritt der Berechnung und Ausgabe der Menge an Abnahme in der Lade- und/oder Entladereaktionsspezies in der detektierten Batterie unter Verwendung der Lade- und/oder Entladekurven der positiven Elektrode und der Lade- und/oder Entladekurven der negativen Elektrode, die in dem zweiten Schritt bestimmt worden sind.

7. Verfahren nach Anspruch 1, ferner umfassend den Schritt der Berechnung und Ausgabe der restlichen Lebensdauer der detektierten Batterie unter Verwendung der Lade- und/oder Entladekurven der positiven Elektrode und der Lade- und/oder Entladekurven der negativen Elektrode, die in dem zweiten Schritt bestimmt worden sind.

8. Verfahren nach Anspruch 1, ferner umfassend die Schritte, dass, während die Tatsache genutzt wird, dass der Wert des Korrekturparameters, der in dem zweiten Schritt verwendet wird, als Anfangswert eingestellt ist, dass die Änderungsrate in dem Korrekturparameter mit der Zeit durch einen polynominalen Ausdruck des Korrekturparameters per se dargestellt wird, und dass die Werte der Koeffizienten ausgedrückt in dem polynominalen Ausdruck von einer Funktion oder einer Tabelle mit wenigstens einer Temperatur und einer Batteriespannung oder einem Elektrodenpotential als Variablen bestimmt wird, wenigstens eine Wert der Korrekturparameter in Bezug auf eine gegebene Benutzungsdauer der Sekundärbatterie bestimmt wird und dass eine Entladekapazität oder einer Ladekapazität der Sekundärbatterie unter Verwendung der Korrekturparameter bestimmt wird, die in der Prozedur bestimmt worden sind, und dass, wenn die so erhaltene Lade- und/oder Entladekapazität mit einem vorher bestimmten Bezugswert übereinstimmt, die Nutzungszeit davon als Lebensdauer der detektierten Batterie definiert wird und die Lebensdauer oder die restlichen Lebensdauer bestimmt wird, die durch die Lebensdauer bestimmt ist.

9. Verfahren nach Anspruch 8, welches eine Prozedur umfasst, um, wenn ein Korrekturparameter x in Bezug auf eine vorgegebene Benutzungsdauer der Sekundärbatterie bestimmt wird, wenigstens eine Kombination aus einer ersten Periode, während der die Sekundärbatterie unter einem ersten Zustand verwendet wird, und eine zweite Periode zu bestimmen, die auf die erste Periode kontinuierlich auf einer Zeitbasis folgt und während der die Sekundärbatterie unter einem zweiten Zustand verwendet wird; um einen Anfangswert x1 des Korrekturparameters x in der ersten Periode zu berechnen und um einen Endwert x2 des Korrekturparameters x in der ersten Periode zu berechnen unter Verwendung des polynominalen Ausdrucks entsprechend dem ersten Zustand oder einer Lösung davon; und um einen Endwert x3 des Korrekturparameters in der zweiten Periode zu berechnen unter Verwendung von x2, welches der Endwert von x in der ersten Periode ist, als Anfangswert des Korrekturparameters in der zweiten Periode und unter Verwendung des polynominalen Ausdrucks entsprechend dem zweiten Zustand oder einer Lösung davon.

10. Vorrichtung zur Erkennung interner Information eines Zustandes einer positiven Elektrode in einer Sekundärbatterie und des Zustandes einer negativen Elektrode in einer Sekundärbatterie, umfassend:
erste Mittel zur Aufnahme als Referenzdaten von Lade- und/oder Entladekurven, die in einem positiven Elektrodenmaterial inhärent sind, und von Lade- und/oder Entladekurven, die in einem negativen positiven Elektrodenmaterial inhärent sind und zur Aufnahme von Lade- und/oder Entladekurven einer detektierten Batterie als tatsächlich gemessene Werte;
zweite Mittel zur Bestimmung von Lade- und/oder Entladekurven einer positiven Elektrode in der detektierten Batterie und Lade- und/oder Entladekurven einer negativen Elektrode darin unter Verwendung der Lade- und/oder Entladekurven, die in dem positiven Elektrodenmaterial inhärent sind, der Lade- und/oder Entladekurven, die in dem negativen Elektrodenmaterial inhärent sind, Lade- und/oder Entladekurven der detektierten Batterie als tatsächlich gemessene Werte, und vorgegebene Korrekturparameter; und
dritten Mittel zur Ausgabe eines Ergebnisses des zweiten Schritts,
**dadurch gekennzeichnet, dass**
die vorgegebenen Korrekturparameter in dem zweiten Schritt vier Parameter umfassen, die einer effektiven, aktiven Materialmasse mₚ[g] einer positiven Elektrode, eine effektive, aktive Materialmasse mₙ[g] einer negativen Elektrode, einem Index Cₚ[Ah], der eine positive Beziehung einer Entladekurve einer positiven Elektrode anzeigt, und einem Index Cₙ[Ah] entsprechen, der eine positive Beziehung der Entladekurve der negativen Elektrode anzeigt, dass die dritten Mittel in der Lage sind, um eines der Lade- und/oder Entladekurven der positiven Elektrode, der Lade- und/oder Entladekurven der negativen Elektrode und der Korrekturparameter wie in der Berechnung verwendet auszugeben, die in den zweiten Mitteln bestimmt worden sind, und dass
die zweiten Mittel umfassen:
Korrekturberechnungsmittel zum Korrigieren der Lade- und/oder Entladekurven, die in dem positiven Elektrodenmaterial inhärent sind, und der Lade- und/oder Entladekurven , die in dem negativen Elektrodenmaterial inhärent sind, unter Verwendung von Korrekturparameter, um positive und negative, aktive Materialmassen, die zu der Ladung oder Entladung beitragen, zu bestimmen und dadurch Lade- und/oder Entladekurven einer insgesamt positiven Elektroden und der Lade- und/oder Entladekurven einer insgesamt negativen Elektrode zu bestimmen,
Korrigieren einer positiven Beziehung zwischen den Lade- und/oder Entladekurven der insgesamt positiven Elektrode und der Lade- und/oder Entladekurven der insgesamt negativen Elektrode unter Verwendung von Korrekturparametern, um eine positive Beziehung zwischen den positiven und negativen Lade- und/oder Entladekurven zu korrigieren und ferner die Lade- und/oder Entladekurven der beiden übereinander zu legen, um dadurch die Lade- und/oder Entladekurven der gesamten Batterie auf der Grundlage von Berechnungen der Gesamtbatterie zu bestimmen, und Bestimmung einer Korrelation zwischen den Lade- und/oder Entladekurven der Gesamtbatterie auf der Basis der Berechnungen und der Lade- und/oder Entladekurven der Gesamtbatterie basierend auf der tatsächlichen Messung;
Korrekturparameter-Identifizierungsmittel zur Identifizierung der Korrekturparameter, wobei die Korrelation in dem Korrelationsberechnungsschritt hoch wird; und
Abschätzungsmittel, um die Lade- und/oder Entladekurven der insgesamt positiven Elektrode und die Lade- und/oder Entladekurven der insgesamt negativen Elektrode abzuschätzen, bei der die positiven Beziehungen unter Verwendung der Korrekturparameter korrigiert werden, die in dem Korrekturparameter-Identifizierungsschritt identifiziert wurden, als Lade- und/oder Entladekurven der insgesamt positiven Elektrode in der Sekundärbatterie und der Lade- und/oder Entladekurven der insgesamt negativen Elektrode in der Sekundärbatterie, und dass ein drittes Mittel zur Ausgabe von wenigstens einem Ergebnis des zweiten Schrittes geeignet ist, um wenigstens eines aus den Lade- und/oder Entladekurven der positiven Elektrode, den Lade- und/oder Entladekurven der negativen Elektrode und den für die Berechnung verwendeten Parametern, die in dem zweiten Schritt bestimmt worden sind, auszugeben.

11. Vorrichtung nach Anspruch 10, wobei, während die Tatsache genutzt wird, dass der Wert des Korrekturparameters, der in dem zweiten Schritt verwendet wird, als Anfangswert eingestellt ist, dass die Änderungsrate in dem Korrekturparameter mit der Zeit durch einen polynominalen Ausdruck des Korrekturparameters per se dargestellt wird, und dass die Werte der Koeffizienten ausgedrückt in dem polynominalen Ausdruck von einer Funktion oder einer Tabelle mit wenigstens einer Temperatur und einer Batteriespannung oder einem Elektrodenpotential als Variablen bestimmt wird, wenigstens ein Wert der Korrekturparameter in Bezug auf eine gegebene Benutzungsdauer der Sekundärbatterie bestimmt wird und dass eine Entladekapazität oder einer Ladekapazität der Sekundärbatterie unter Verwendung der Korrekturparameter bestimmt wird, die in der Prozedur bestimmt worden sind, und dass, wenn die so erhaltene Lade- und/oder Entladekapazität mit einem vorher bestimmten Bezugswert übereinstimmt, die Nutzungszeit davon als Lebensdauer der detektierten Batterie definiert wird und die Lebensdauer oder die restlichen Lebensdauer bestimmt wird, die durch die Lebensdauer bestimmt ist.

## Revendications

1. Procédé pour détecter les informations internes de la situation d'une électrode positive dans une batterie secondaire et de la situation d'une électrode négative dans une batterie secondaire, comprenant:
- une première étape pour acquérir les courbes de chargement et/ou de déchargement inhérentes dans un matériau d'électrode positive et les courbes de chargement et/ou de déchargement inhérentes dans un matériau d'électrode négative, comme des données de référence, et pour acquérir les courbes de chargement et/ou de déchargement d'une batterie détectée comme des valeurs effectivement mesurées;
- une seconde étape pour déterminer les courbes de chargement et/ou de déchargement d'une électrode positive dans la batterie détectée et les courbes de chargement et/ou de déchargement d'une électrode négative là dedans, en utilisant les courbes de chargement et/ou de déchargement inhérentes dans le matériau d'électrode positive, les courbes de chargement et/ou de déchargement inhérentes dans le matériau d'électrode négative, les courbes de chargement et/ou de déchargement de la batterie détectée comme des valeurs effectivement mesurées, et les paramètres de correction prédéterminés; et
- une troisième étape pour délivrer un résultat de la seconde étape,
**caractérisé en ce que**
- les paramètres de correction prédéterminés dans la seconde étape comprennent quatre paramètres qui correspondent à une masse de matériau active efficace d'électrode positive mp[g], à une masse de matériau active efficace d'électrode négative mₙ[g], à un index Cp[Ah] indicatif d'une relation de position d'une courbe de déchargement d'électrode positive, et à un index Cₙ[Ah] indicatif d'une relation de position d'une courbe de déchargement d'électrode négative, que
- la seconde étape comprend:
- une étape de calcul de corrélation pour corriger les courbes de chargement et/ou de déchargement inhérentes dans le matériau d'électrode positive et les courbes de chargement et/ou de déchargement inhérentes dans le matériau d'électrode négative, en utilisant les paramètres de correction pour corriger les masses de matériau actives positives et négatives qui contribuent au chargement et/ou déchargement et de cette manière en déterminant les courbes de chargement et/ou de déchargement d'une électrode globale positive et les courbes de chargement et/ou de déchargement d'une électrode globale négative, en corrigeant une relation de position entre les courbes de chargement et/ou de déchargement de l'électrode globale positive et les courbes de chargement et/ou de déchargement de l'électrode globale négative, en utilisant le paramètre de correction pour corriger une relation de position entre les courbes de chargement et/ou de déchargement positives et négatives et de plus superposant les courbes de chargement et/ou de déchargement des deux de ce fait pour déterminer les courbes de chargement et/ou de déchargement de la batterie globale basées sur les calculs de la batterie globale, et en déterminant une corrélation entre les courbes de chargement et/ou de déchargement de la batterie globale basée sur les calculs et les courbes de chargement et/ou de déchargement de la batterie globale basées sur la mesure réelle;
- une étape d'identification de paramètres de correction pour identifier les paramètres de correction où la corrélation devient importante dans l'étape de calcul de la corrélation; et
- une étape d'estimation pour estimer les courbes de chargement et/ou de déchargement de l'électrode globale positive et les courbes de chargement et/ou de déchargement de l'électrode globale négative à laquelle la relation de position est corrigée en utilisant les paramètres de correction identifiés dans l'étape d'identification de paramètres de correction, comme les courbes de chargement et/ou de déchargement de l'électrode globale positive dans la batterie secondaire et les courbes de chargement et/ou de déchargement de l'électrode globale négative dans la batterie secondaire, et que
- dans la troisième étape, au moins l'une d'entre les courbes de chargement et/ou de déchargement de l'électrode positive, les courbes de chargement et/ou de déchargement de l'électrode négative et les paramètres de correction utilisés pour le calcul, qui ont été déterminés à ladite seconde étape, sont délivrés.

2. Procédé selon la revendication 1, où les courbes de chargement et/ou de déchargement indiquent les relations entre les quantités de chargement et/ou de déchargement d'électricité et les valeurs de changements dans les tensions relatives aux valeurs de changements dans les quantités de chargement et/ou de déchargement d'électricité.

3. Procédé selon la revendication 1, incluant de plus l'étape de délivrer un signal pour recommander le remplacement de la batterie détectée où l'un quelconque d'entre un domaine de potentiel utilisé des courbes de chargement et/ou de déchargement de l'électrode positive, un domaine de potentiel utilisé des courbes de chargement et/ou de déchargement de l'électrode négative et le paramètre de correction utilisé dans le calcul, qui ont été déterminés dans la seconde étape, tombent dans un domaine prédéterminé.

4. Procédé selon la revendication 1, incluant de plus l'étape de, quand le potentiel de l'électrode positive ou négative dans un domaine d'utilisation de la batterie défini par les tensions de limite supérieure et limite inférieure de la batterie détectée tombe à l'extérieur d'un domaine prédéterminé aux courbes de chargement et/ou de déchargement de l'électrode positive et aux courbes de chargement et/ou de déchargement de l'électrode négative, qui ont été déterminées dans la seconde étape, la tension de limite supérieure ou de limite inférieure de la batterie détectée est de nouveau ajustée de telle manière que le potentiel de l'électrode positive ou négative tombe dans un domaine prédéterminé.

5. Procédé selon la revendication 1, incluant de plus l'étape de donner un avertissement en ce qui concerne le risque d'un court-circuit interne à la batterie détectée où le potentiel de l'électrode négative située dans un état complètement chargé calculé en utilisant les courbes de chargement et/ou de déchargement de l'électrode positive et les courbes de chargement et/ou de déchargement de l'électrode négative, qui ont été déterminées dans la seconde étape, tombe dans un domaine prédéterminé.

6. Procédé selon la revendication 1, incluant de plus l'étape de calculer et délivrer la valeur d'une réduction dans les espèces de réaction de chargement et/ou de déchargement dans la batterie détectée en utilisant les courbes de chargement et/ou de déchargement de l'électrode positive et les courbes de chargement et/ou de déchargement de l'électrode négative, qui ont été déterminées dans la seconde étape.

7. Procédé selon la revendication 1, incluant de plus l'étape de calculer et délivrer la durée de vie restante de la batterie détectée en utilisant les courbes de chargement et/ou de déchargement de l'électrode positive et les courbes de chargement et/ou de déchargement de l'électrode négative, qui ont été déterminées dans la seconde étape.

8. Procédé selon la revendication 1, incluant de plus l'étape d', utiliser le fait que la valeur du paramètre de correction utilisé dans la seconde étape est définie comme une valeur initiale, la vitesse de changement dans le paramètre de correction avec le temps est représentée par une expression polynominale du paramètre de correction en soi, et les valeurs des coefficients de termes dans l'expression polynominale sont déterminées à partir d'une fonction ou d'un tableau avec au moins une température et une tension de batterie ou un potentiel d'électrode comme des variables, en déterminant au moins une valeur des paramètres de correction par rapport à un temps donné d'utilisation de la batterie secondaire et en déterminant une capacité de déchargement ou une capacité de chargement de la batterie secondaire en utilisant les paramètres de correction déterminés dans ladite procédure, et de, quand la capacité de chargement ou déchargement ainsi obtenue coïncide avec une valeur de référence déterminée en avance, définissant le temps d'utilisation de celle-ci comme une durée de vie de la batterie détectée et en déterminant la durée de vie ou la durée de vie restante déterminée de la durée de vie.

9. Procédé selon la revendication 8, qui comprend une procédure de, quand un paramètre de correction X par rapport au temps d'utilisation donné de la batterie secondaire est déterminé, définir au moins une combinaison d'une première période pendant laquelle la batterie secondaire est utilisé sous une première condition, et une seconde période qui suivit la première période continuellement sur une base de temps et pendant lequel la seconde batterie est utilisée sous une seconde condition; calculer une valeur initiale x1 du paramètre de correction X dans la première période, et calculer une valeur finale x2 du paramètre de correction X dans la première période, en utilisant l'expression polynominale correspondant à la première condition ou une solution de celle-ci; et calculer une valeur finale x3 du paramètre de correction dans la seconde période, en utilisant x2, qui est la valeur finale de x dans la première période, comme une valeur initiale du paramètre de correction dans la seconde période et utilisant l'expression polynominale correspondant à la seconde condition ou une solution de celle-ci.

10. Appareil pour détecter les informations internes de la situation d'une électrode positive dans une batterie secondaire et la situation d'une électrode négative dans une batterie secondaire, comprenant:
- le premier moyen pour acquérir, comme donnes de référence, les courbes de chargement et/ou de déchargement inhérentes dans un matériau d'électrode positive et les courbes de changement et/ou de déchargement inhérentes dans un matériau d'électrode négative et acquérir les courbes de chargement et/ou de déchargement d'une batterie détectée comme des valeurs effectivement mesurées;
- le second moyen pour déterminer les courbes de chargement et/ou de déchargement d'une électrode positive dans la batterie détectée et les courbes de chargement et/ou de déchargement d'une électrode négative là dedans, en utilisant les courbes de chargement et/ou de déchargement inhérentes dans le matériau d'électrode positive, les courbes de chargement et/ou de déchargement inhérentes dans le matériau d'électrode négative, les courbes de chargement et/ou de déchargement de la batterie détectée comme des valeurs effectivement mesurées, et les paramètres de correction prédéterminés; et
- le troisième moyen pour délivrer un résultat de la seconde étape,
**caractérisé en ce que**
- les paramètres de correction prédéterminés dans la seconde étape comprennent quatre paramètres qui correspondent à une masse de matériau active efficace d'électrode positive mp[g], à une masse de matériau active efficace d'électrode négative mₙ[g], à un index Cₚ[Ah] indicatif d'une relation de position d'une courbe de déchargement d'électrode positive, et à un index Cₙ[Ah] indicatif d'une relation de position d'une courbe de déchargement d'électrode négative, que le troisième moyen est adapté pour délivrer l'une d'entre les courbes de chargement et/ou de déchargement de l'électrode positive, les courbes de chargement et/ou de déchargement de l'électrode négative et les paramètres de correction utilisés dans le calcul, qui ont été déterminés par le second moyen, et que
- le second moyen comprend:
- le moyen de calcul de corrélation pour corriger les courbes de chargement et/ou de déchargement inhérentes dans le matériau d'électrode positive et les courbes de chargement et/ou de déchargement inhérentes dans le matériau d'électrode négative, en utilisant un premier paramètre de correction pour corriger les masses de matériau actives positives et négatives qui contribuent au chargement et/ou déchargement et de cette manière en déterminant les courbes de chargement et/ou de déchargement de l'électrode globale positive et les courbes de chargement et/ou de déchargement d'une électrode globale négative, en corrigeant une relation de position entre les courbes de chargement et/ou de déchargement de l'électrode globale positive et les courbes de chargement et/ou de déchargement de l'électrode globale négative en utilisant les paramètres de correction pour corriger la relation de position entre les courbes de chargement et/ou de déchargement positives et négatives et de plus superposant toutes les deux courbes de chargement et/ou de déchargement les unes sur les autres de cette manière pour déterminer les courbes de chargement et/ou de déchargement de la batterie globale basées sur les calcules de la batterie globale, et en déterminant une corrélation entre les courbes de chargement et/ou de déchargement de la batterie globale basée sur les calcules et les courbes de chargement et/ou de déchargement de la batterie globale basées sur la mesure réelle;
- le moyen d'identification de paramètres de correction pour identifier les paramètres de correction où la corrélation devient importante dans l'étape de calcul de la corrélation; et
- le moyen d'estimation pour estimer les courbes de chargement et/ou de déchargement de l'électrode globale positive et les courbes de chargement et/ou de déchargement de l'électrode globale négative auquel la relation de position est corrigée en utilisant les paramètres de correction identifiés dans le moyen d'identification de paramètres de correction, comme les courbes de chargement et/ou de déchargement de l'électrode globale positive dans la batterie secondaire et les courbes de chargement et/ou de déchargement de l'électrode globale négative dans la batterie secondaire, et que
- le troisième moyen pour délivrer au moins un résultat de la seconde étape est adapté pour délivrer au moins l'une d'entre les courbes de chargement et/ou de déchargement de l'éléctrode positive, les courbes de chargement et/ou de déchargement de l'électrode négative et les paramètres de correction utilisés pour le calcul, qui ont été déterminés à ladite seconde étape.

11. Appareil selon la revendication 10, où, en utilisant le fait que la valeur du paramètre de correction utilisé dans le second moyen est définie comme une valeur initiale, la vitesse de changement dans le paramètre de correction avec le temps est représentée par une expression polynominale du paramètre de correction en soi, et les valeurs des coefficients de termes respectifs dans l'expression polynominale sont déterminées à partir d'une fonction ou d'un tableau avec au moins une température et une tension de batterie ou un potentiel d'électrode comme des variables, au moins une valeur du paramètre de correction est déterminée par rapport à un temps donné d'utilisation de la batterie secondaire, et une capacité de déchargement ou une capacité de chargement de la batterie secondaire est déterminée utilisant au moins l'un d'entre les paramètres de correction déterminés dans la procédure, et où, quand la capacité de chargement ou déchargement ainsi obtenue coïncide avec une valeur de référence déterminée en avance, le temps d'utilisation de celle-ci est défini comme une durée de vie de la batterie détectée et la durée de vie ou la durée de vie restante déterminée de la durée de vie est déterminée.
